# EUROPEAN PATENT APPLICATION

(11) **EP 3 952 622 A1**
(43) Date of publication of application: **09.02.2022**
(21) Application number: 20777072.8
(22) Date of filing: 19.03.2020
(51) Int. Cl.: H05K 3/36, H05K 1/11

(54) **CIRCUIT BOARD INCLUDING CONNECTION STRUCTURE AND ELECTRONIC DEVICE INCLUDING SAME**

(30) Priority: 25.03.2019 KR 20190033557
(71) Applicant: Samsung Electronics Co., Ltd., Suwon-si, Gyeonggi-do 16677 (KR)
(72) Inventor: LEE, Yongwon, Suwon-si Gyeonggi-do 16677 (KR); KIM, Jeonghoo, Suwon-si Gyeonggi-do 16677 (KR); KIM, Joohan, Suwon-si Gyeonggi-do 16677 (KR); RHEE, Bongjae, Suwon-si Gyeonggi-do 16677 (KR); YANG, Seyoung, Suwon-si Gyeonggi-do 16677 (KR); JANG, Seyoung, Suwon-si Gyeonggi-do 16677 (KR)
(74) Representative: Nederlandsch Octrooibureau
(86) International application number: PCT/KR2020/003776
(87) International publication number: WO 2020/197169

(57) **Abstract**

Described are various embodiments related to a circuit board included in an electronic device. According to an embodiment, the circuit board includes: a first circuit board, on which at least one circuit element or at least one first electronic component included in an electronic device, is mounted; a second circuit board, on which at least one second electronic component included in the electronic device, is mounted; and a connection structure electrically connecting the first circuit board and the second circuit board through soldering. The connection structure includes: a first connection terminal disposed on the first circuit board and including at least one first connection pad; and a second connection terminal disposed on the second circuit board and including at least one second connection pad. The at least one second connection pad faces the at least one first connection pad and is electrically connected to the at least one first connection pad through the soldering. The at least one second connection pad may include a plurality of contact members which are in surface contact with a solder provided by the soldering. Various other embodiments are possible.

## Description

### [Technical Field]

Various embodiments of the disclosure relate to a circuit board including a connection structure, and an electronic device including the circuit board.

### [Background Art]

Electronic devices may output stored information as sounds or images. In line with a high degree of integration of electronic devices and widespread use of super-fast larger-capacity wireless communication of late, a single electronic device (for example, mobile communication terminal) may be equipped with various functions. For example, not only a communication function, but also an entertainment function (for example, gaming), a multimedia function (for example, music/moving image playback), communication and security functions for mobile banking, a scheduling function, and an electronic wallet function are integrated in a single electronic device.

In line with increasing attention to compactness, slimness, and high density of electronic devices, circuit boards included in electronic devices need to be integrated and lightweight. For example, for the purpose of compactness, slimness, and high density of electronic devices, board wires are mounted on both surfaces of the circuit board with a high density. The circuit board may be made of a rigid flexible PCB (RF PCB) in order to electrically connect the board wires.

### [Detailed Description of the Invention]

### [Technical Problem]

An RF PCB includes a hard circuit board and an FPCB (flexible board), and the circuit board and the FPCB may be electrically connected to each other by a connector. If the circuit board and the FPCB of the RF PCB are electrically connected to each other by using a connector, the FPCB (flexible board) may be detached or bent, thereby generating a crack, and this may cause poor electric connection of the circuit board.

An embodiment of the disclosure may provide a circuit board and an electronic device including the same, wherein the circuit board includes a connection structure capable of improving electric connection between a first circuit board (for example, PCB) and a second circuit board (for example, FPCB) by configuring multiple contact members that make surface contact with a solder formed by soldering, without using a conventional connector.

An embodiment of the disclosure may provide a circuit board and an electronic device including the same, wherein the circuit board includes a connection structure configured to connect a first circuit board (for example, PCB) and a second circuit board (for example, FPCB) by a contactless jet soldering process which generates no heat.

### [Technical Solution]

According to various embodiments of the disclosure, a circuit board including a connection structure may include: a first circuit board on which at least one circuit element or at least one first electronic component included in an electronic device is mounted; a second circuit board on which at least one second electronic component included in the electronic device is mounted; and a connection structure electrically connecting the first circuit board and the second circuit board to each other by soldering, wherein the connection structure includes: a first connection terminal disposed on the first circuit board and including at least one first connection pad; and a second connection terminal disposed on the second circuit board and including at least one second connection pad, wherein the at least one second connection pad faces the at least one first connection pad and is electrically connected to the at least second connection pad by the soldering, and wherein the at least one second connection pad includes a plurality of contact members which are in surface contact with a solder provided by the soldering.

According to various embodiments of the disclosure, an electronic device may comprise: a housing comprising a front plate, a rear plate facing in an opposite direction from the front plate, and a side surface surrounding a space between the front plate and the rear plate; a first circuit board located inside the housing, and on which at least one circuit element or at least one first electronic component included in the electronic device is mounted; a second circuit board located inside the housing, and on which at least one second electronic component included in the electronic device is mounted; and a connection structure electrically connecting the first circuit board and the second circuit board to each other by soldering, wherein the connection structure includes: a first connection terminal disposed on the first circuit board and includes at least one first connection pad; and a second connection terminal disposed on the second circuit board and includes at least one second connection pad, wherein the at least one second connection pad faces the at least one first connection pad and is electrically connected to the at least one first connection pad by soldering, and wherein the at least one second connection pad includes a plurality of contact members which are in surface contact with a solder provided by the soldering.

According to various embodiments of the disclosure, a circuit board may include: a first circuit board including a first connection terminal; a second circuit board including a second connection terminal; at least one first connection pad disposed on the first connection terminal; and at least one second connection pad disposed on the second connection terminal, facing the at least one first connection pad, and electrically connected to the at least one first connection pad by soldering, wherein the at least one second connection pad includes a plurality of contact members which are in surface contact with a solder provided by the soldering.

### [Advantageous Effects]

According to at least one of the technical solutions of the disclosure described above, the first connection terminal of the first circuit board (for example, PCB) and the second connection terminal of the second circuit board (for example, FPCB) are electrically connected by soldering according to an embodiment of the disclosure. The second connection terminal includes a second connection pad including multiple contact members that make surface contact with the solder formed by soldering. As a result, the second connection pad has an increased area of contact with the solder through the multiple contact members, and this may improve the electric connection between the first and second connection pads. In addition, there is no need for a conventional connection scheme (connector), and it is thus possible to prevent a crack of the circuit board, which would occur if a conventional connector is used, thereby preventing poor electric connection of the product. Moreover, since no space is necessary inside the electronic device to install a conventional connector, product space utilization and the degree of installation freedom are improved, and product manufacturing costs can also be reduced.

According to an embodiment of the disclosure, the first connection terminal of the first circuit board (for example, PCB) and the second connection terminal of the second circuit board (for example, FPCB) may be electrically connected by a contactless jet soldering process, which generates no heat, thereby preventing damage to electronic components (for example, active area of the display) included in the electronic device. For example, using a contactless jet soldering process to electrically connect the first circuit board (for example, PCB) and the second circuit board (for example, FPCB) may prevent thermal damage to electronic components, compared with a conventional soldering process which generates heat. For example, the contactless jet soldering process may also be applied to an electronic component (for example, fingerprint recognition module) provided on the back surface of the display such that the display, which is vulnerable to heat, is prevented by from being damaged by heat.

### [Brief Description of Drawings]

FIG. 1 is a block diagram of an electronic device in a network environment according to various embodiments;
FIG. 2 is a front perspective view of an electronic device according to various embodiments of the disclosure;
FIG. 3 is a rear perspective view of an electronic device according to various embodiments of the disclosure;
FIG. 4 is an exploded perspective view of an electronic device according to various embodiments of the disclosure;
FIG. 5 is a plan view illustrating a coupling state of a connection structure included in first and second circuit boards according to various embodiments of the disclosure;
FIG. 6 is a plan view of enlarged part A of FIG. 5, illustrating a first connection pad included in a first connection terminal of a first circuit board, among components of the connection structure;
FIG. 7 is a plan view of enlarged part A of FIG. 5, illustrating a second connection pad included in a second connection terminal of a second circuit board, among the components of the connection structure;
FIG. 8A is a three-dimensional view illustrating a second connection pad included in a second circuit board according to various embodiments of the disclosure;
FIG. 8B is a front view illustrating the second connection pad included in the second circuit board according to various embodiments of the disclosure;
FIG. 8C is a side view illustrating the second connection pad included in the second circuit board according to various embodiments of the disclosure;
FIG. 9A is a plan view illustrating operating states of first and second connection pads included in first and second circuit boards according to various embodiments of the disclosure;
FIG. 9B is a side view illustrating an operation state of a soldering device according to various embodiments of the disclosure;
FIG. 9C is a side view illustrating a state in which the first and second connection pads included in the first and second circuit boards, respectively, are electrically connected to each other by soldering according to various embodiments of the disclosure;
FIG. 10 is a plan view illustrating a first connection pad included in a first connection terminal of a first circuit board, among components of a connection structure according to various other embodiments of the disclosure;
FIG. 11 is a plan view illustrating a second connection pad included in a second connection terminal of a second circuit board, among components of a connection structure according to various other embodiments of the disclosure;
FIG. 12A is a three-dimensional view illustrating a second connection pad included in a second circuit board according to various other embodiments of the disclosure;
FIG. 12B is a front view illustrating the second connection pad included in the second circuit board according to various other embodiments of the disclosure;
FIG. 12C is a side view illustrating the second connection pad included in the second circuit board according to various other embodiments of the disclosure;
FIG. 13A is a plan view illustrating operating states of first and second connection pads included in first and second circuit boards, respectively, according to various other embodiments of the disclosure; and
FIG. 13B is a side view illustrating the operating states of the first and second connection pads included in the first and second circuit boards, respectively, according to various other embodiments of the disclosure.

### [Mode for Carrying out the Invention]

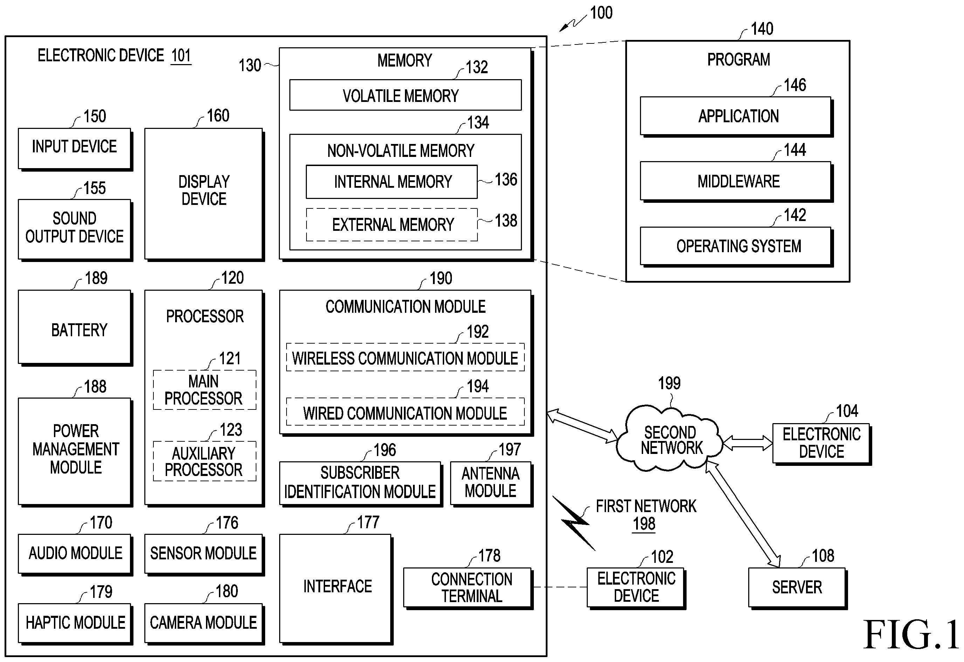

FIG. 1 is a block diagram illustrating an electronic device 101 in a network environment 100 according to various embodiments.

Referring to FIG. 1, the electronic device 101 in the network environment 100 may communicate with an electronic device 102 via a first network 198 (e.g., a short-range wireless communication network), or an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input device 150, a sound output device 155, a display device 160, an audio module 170, a sensor module 176, an interface 177, a haptic module 179, a camera module 180, a power management module 188, a battery 189, a communication module 190, a subscriber identification module (SIM) 196, or an antenna module 197. In some embodiments, at least one (e.g., the display device 160 or the camera module 180) of the components may be omitted from the electronic device 101, or one or more other components may be added in the electronic device 101. In some embodiments, some of the components may be implemented as single integrated circuitry. For example, the sensor module 176 (e.g., a fingerprint sensor, an iris sensor, or an illuminance sensor) may be implemented as embedded in the display device 160 (e.g., a display).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may load a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), and an auxiliary processor 123 (e.g., a graphics processing unit (GPU), an image signal processor (ISP), a sensor hub processor, or a communication processor (CP)) that is operable independently from, or in conjunction with, the main processor 121. Additionally or alternatively, the auxiliary processor 123 may be adapted to consume less power than the main processor 121, or to be specific to a specified function. The auxiliary processor 123 may be implemented as separate from, or as part of the main processor 121.

The auxiliary processor 123 may control, for example, at least some of functions or states related to at least one component (e.g., the display device 160, the sensor module 176, or the communication module 190) among the components of the electronic device 101, instead of the main processor 121 while the main processor 121 is in an inactive (e.g., sleep) state, or together with the main processor 121 while the main processor 121 is in an active (e.g., executing an application) state. According to an embodiment, the auxiliary processor 123 (e.g., an image signal processor or a communication processor) may be implemented as part of another component (e.g., the camera module 180 or the communication module 190) functionally related to the auxiliary processor 123.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input device 150 may receive a command or data to be used by a component (e.g., the processor 120) of the electronic device 101, from the outside (e.g., a user) of the electronic device 101. The input device 150 may include, for example, a microphone, a mouse, or a keyboard.

The sound output device 155 may output sound signals to the outside of the electronic device 101. The sound output device 155 may include, for example, a speaker or a receiver. The speaker may be used for general purposes, such as playing multimedia or playing record, and the receiver may be used for incoming calls. According to an embodiment, the receiver may be implemented as separate from, or as part of the speaker.

The display device 160 may visually provide information to the outside (e.g., a user) of the electronic device 101. The display device 160 may include, for example, a display, a hologram device, or a projector and control circuitry to control a corresponding one of the display, hologram device, and projector. According to an embodiment, the display device 160 may include touch circuitry adapted to detect a touch, or sensor circuitry (e.g., a pressure sensor) adapted to measure the intensity of force incurred by the touch.

The audio module 170 may convert a sound into an electrical signal and vice versa. According to an embodiment, the audio module 170 may obtain the sound via the input device 150, or output the sound via the sound output device 155 or an external electronic device (e.g., an electronic device 102 (e.g., a speaker or a headphone)) directly or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, an HDMI connector, a USB connector, an SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image and moving images. According to an embodiment, the camera module 180 may include one or more lenses, image sensors, image signal processors, or flashes.

The power management module 188 may manage power supplied to the electronic device 101. According to one embodiment, the power management module 388 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and support a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as BluetoothTM, wireless-fidelity (Wi-Fi) direct, or infrared data association (IrDA)) or the second network 199 (e.g., a long-range communication network, such as a cellular network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The antenna module 197 may transmit or receive a signal or power to or from the outside (e.g., the external electronic device) of the electronic device 101. According to an embodiment, the antenna module 197 may include one or more antennas, and at least one antenna appropriate for a communication scheme used in the communication network, such as the first network 198 or the second network 199, may be selected, for example, by the communication module 190 from the one or more antennas. The signal or the power may then be transmitted or received between the communication module 190 and the external electronic device via the selected at least one antenna.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 and 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, or client-server computing technology may be used, for example.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used herein, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStoreTM), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities. According to various embodiments, one or more of the above-described components or operations may be omitted, or one or more other components or operations may be added. Alternatively or additionally, a plurality of components (e.g., modules or programs) may be integrated into a single component. In such a case, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

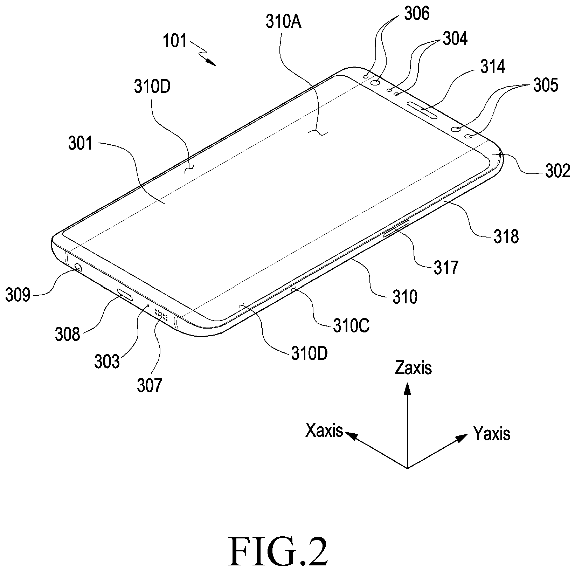

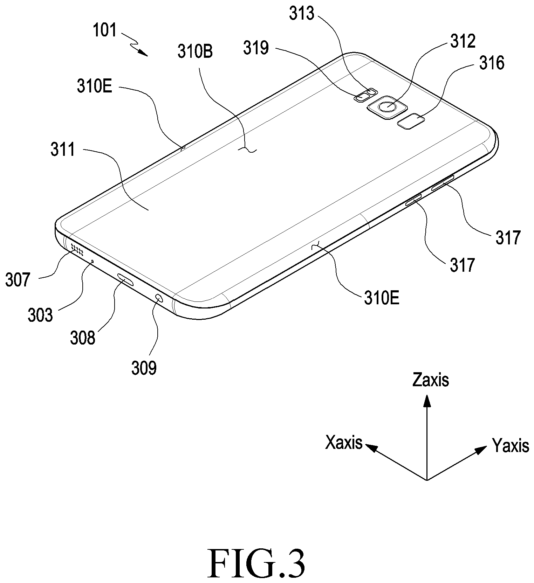

FIG. 2 is a front perspective view of an electronic device 101 according to various embodiments of the disclosure and FIG. 3 is a rear perspective view of the electronic device 101 according to various embodiments of the disclosure.

Referring to FIGS. 2 and 3, the electronic device 101 according to one embodiment may include a housing 310 including a first surface (or front surface) 310A, a second surface (or rear surface) 310B, and a side surface 310C surrounding a space between the first surface 310A and the second surface 310B. In another embodiment (not shown), a structure configuring a portion of the first surface 310A of FIG. 2, the second surface 310B, and the side surfaces 310C may be referred to as a housing. According to one embodiment, the first surface 310A may be configured by a front plate 302 (e.g., glass plate, or polymer plate including various coating layers) having at least a portion which is substantially transparent. The second surface 310B may be configured by a rear plate 311 which is substantially opaque. The rear plate 311 may be configured by, for example, coated or colored glass, ceramic, a polymer, a metal (e.g., aluminum, stainless steel (STS), or magnesium), or a combination of at least two thereof. The side surface 310C may be configured by a side bezel structure (or "side surface member") 318 that is coupled to the front plate 302 and the rear plate 311 and includes a metal and/or a polymer. In an embodiment, the rear plate 311 and side bezel structure 318 may be integrally formed with each other and include the same material (e.g., a metal material such as aluminum).

In the illustrated embodiment, the front plate 302 may include two first regions 310D, which are arranged at opposite ends of the longer edges of the front surface plate 302, respectively, and are curved and seamlessly extend from the first surface 310A toward the rear plate 311. In the illustrated embodiment (see FIG. 3), the rear plate 311 may include two second regions 310E, which are arranged at opposite ends of the longer edges thereof, respectively, and are curved and seamlessly extend from the second surface 310B toward the front plate 302. In an embodiment, the front plate 302 (or the rear plate 311) may include only one of the first regions 310D (or the second regions 310E). In another embodiment, the electronic device may not include one of the first regions 310D or the second regions 310E. In the above embodiments, when viewed from the side of the electronic device 101, the side bezel structure 318 may have a first thickness (or width) on a side surface including no first regions 310D or second regions 310E and may have a second thickness, thinner than the first thickness, on a side surface including the first regions 310D or the second regions 310E.

According to one embodiment, the electronic device 101 may include at least one of a display 301, audio modules 303, 307, and 314, sensor modules 304, 316, and 319, camera modules 305, 312, and 313, key input devices 317, a light-emitting element 306, and connector holes 308 and 309. In an embodiment, at least one of the elements (e.g., key input devices 317 or the light-emitting element 306) may be omitted from the electronic device 101 or another element may be added to the electronic device 101.

According to one embodiment, the display 301 may be visually exposed, for example, through a significant portion of the front plate 302. In an embodiment, at least a portion of the display 301 may be exposed through the front plate 302 forming the first surface 310A and the first regions 310D of the side surface 310C. In an embodiment, the edge of the display 301 may be configured to have substantially the same shape as the outer edge of the front plate 302 adjacent thereto. In another embodiment (not shown), in order to expand an area where the display 301 is exposed, the display 301 may be configured such that the distance between the outer edge of the display 301 and the outer edge of the front plate 302 is maintained to be substantially the same.

In another embodiment (not shown), a portion of a screen display region of the display 301 may have a recess or opening formed therethrough and include at least one of the audio module 314, the sensor module 304, the camera module 305, and the light-emitting element 306, which are aligned with the recess or the opening. In another embodiment (not shown), the rear surface of the screen display region of the display 301 may include at least one of the audio module 314, the sensor module 304, the camera module 305, a fingerprint sensor 316, and the light-emitting element 306. In another embodiment (not shown), the display 301 may be coupled or adjacent to a touch sensing circuit, a pressure sensor capable of measuring the intensity (pressure) of touch, and/or a digitizer for detecting a magnetic field type stylus pen. In an embodiment, at least one of the sensor modules 304 and 519 and/or at least one of the key input devices 317 may be disposed on the first regions 310D and/or the second regions 310E.

The audio modules 303, 307, and 314 may include, for example, a microphone hole 303 and speaker holes 307 and 314. A microphone for acquiring external sound may be disposed inside the microphone hole 303, and in an embodiment, a plurality of microphones may be arranged inside thereof so as to sense the direction of sound. The speaker holes 307 and 314 may include an external speaker hole 307 and a call receiver hole 314. In an embodiment, the speaker holes 307 and 314 and the microphone hole 303 may be implemented by one hole, or a speaker may be provided without the speaker holes 307 and 314 (e.g., piezo speaker).

The sensor modules 304, 316, and 319 may generate an electrical signal or a data value corresponding to, for example, an internal operating state or an external environmental state of the electronic device 101. The sensor modules 304, 316, and 319 may include, for example, a first sensor module 304 (e.g., proximity sensor) and/or a second sensor module (not shown) (e.g., fingerprint sensor) disposed on the first surface 310A of the housing 310, and/or a third sensor module 319 (e.g., HRM sensor) and/or a fourth sensor module 316 (e.g., fingerprint sensor) disposed on the second surface 310B of the housing 310. The fingerprint sensor may be disposed not only on the first surface 310A (e.g., display 301) of the housing 310 but also on the second surface 310B thereof. The electronic device 101 may further include a sensor module which are not shown, for example, at least one of a gesture sensor, a gyro sensor, a barometric pressure sensor, a magnetic sensor, an acceleration sensor, a grip sensor, a color sensor, an infrared (IR) sensor, a biometric sensor, a temperature sensor, a humidity sensor, or an illuminance sensor 304.

The camera modules 305, 312, and 313 may include, for example, a first camera device 305 disposed on the first surface 310A of the electronic device 101, and a second camera device 312 and/or a flash 313 disposed on the second surface 310B thereof. The camera modules 305 and 312 may include one or more lenses, an image sensor, and/or an image signal processor. The flash 313 may include, for example, a light-emitting diode or a xenon lamp. In an embodiment, two or more lenses (infrared camera, wide-angle and telephoto lenses) and image sensors may be disposed on one surface of the electronic device 101.

The key input devices 317 may be, for example, disposed on the side surface 310C of the housing 310. In another embodiment, the electronic device 101 may not include one or all of the key input devices 317 mentioned above, and the key input device 317 that is not included on the electronic device 101 may be implemented in a different form such as a soft key or the like on the display 301. In an embodiment, the key input devices may include the sensor module 316 disposed on the second surface 310B of the housing 310.

The light-emitting device 306 may be disposed, for example, on the first surface 310A of the housing 310. The light-emitting element 306 may provide, for example, state information of the electronic device 101 in the form of light. In another embodiment, the light-emitting device 306 may provide, for example, a light source interworking with the operation of the camera module 305. The light-emitting element 306 may include, for example, an LED, an IR LED, and a xenon lamp.

The connector holes 308 and 309 may include a first connector hole 308 that can receive a connector (e.g., USB connector) for transmitting and receiving power and/or data to and from an external electronic device, and/or a second connector hole 309 (e.g., earphone jack) that can receive a connector for transmitting and receiving an audio signal to and from an external electronic device.

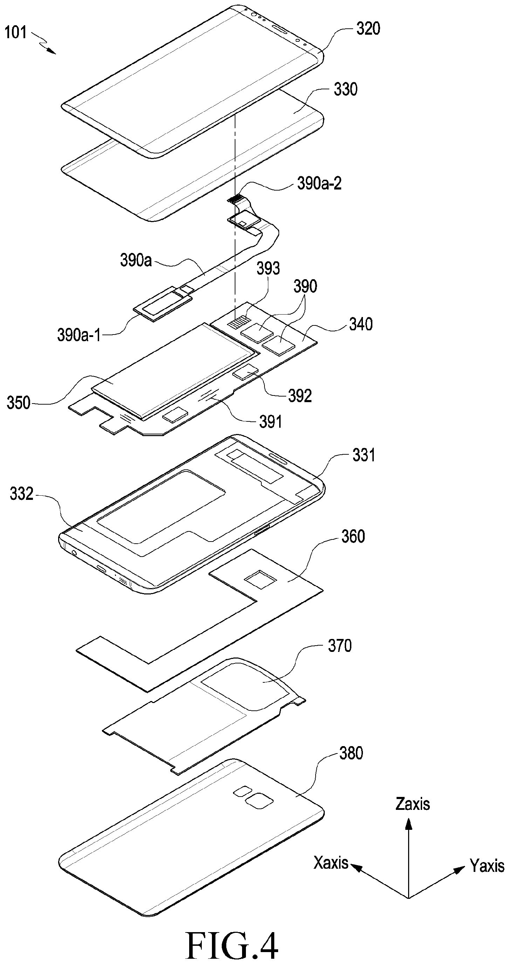

FIG. 4 is an exploded perspective view of the electronic device 101 according to various embodiments of the disclosure.

Referring to FIG. 4, the electronic device 101 (e.g., the electronic device 101 of FIGS. 1 to 3) may include a side bezel structure 331, a first support member 332 (e.g., bracket), a front plate 320, a display 330, a printed circuit board 340, a battery 350, a second support member 360 (e.g., rear case), an antenna 370, and a rear plate 380. In an embodiment, at least one of the elements (e.g., the first support member 332, or the second support member 360) may be omitted from the electronic device 101 or another element may be added to the electronic device 101. At least one of the elements of the electronic device 101 may be the same as or similar to at least one of the elements of the electronic device 101 of FIG. 2 or 3 and overlapping description thereof will be omitted.

The first support member 332 may be disposed inside the electronic device 101 to be connected to the side bezel structure 331 or may be integrally configured with the side bezel structure 331. The first support member 332 may be formed of, for example, a metal material and/or a non-metal (e.g., polymer) material. The first support member 332 may have one surface coupled to the display 330 and the other surface coupled to the printed circuit board 340. The printed circuit board 340 may be equipped with a processor, a memory, and/or an interface. The processor may include, for example, one or more of a central processing unit, an application processor, a graphic processing unit, an image signal processor, a sensor hub processor, or a communication processor.

The memory may include, for example, a volatile memory or a nonvolatile memory.

The interface may include, for example, a high definition multimedia interface (HDMI), a universal serial bus (USB) interface, an SD card interface, and/or an audio interface. The interface may, for example, electrically or physically connect the electronic device 101 to an external electronic device and may include a USB connector, an SD card/MMC connector, or an audio connector.

The battery 350, which is a device for supplying power to at least one element of the electronic device 101, may include, for example, a non-rechargeable primary cell, a rechargeable secondary cell, or a fuel battery. At least a portion of the battery 350 may be disposed on, for example, substantially the same plane as the printed circuit board 340. The battery 350 may be integrally disposed inside the electronic device 101 or may be disposed to be attachable to or detachable from the electronic device 101.

The antenna 370 may be disposed between the rear plate 380 and the battery 350. The antenna 370 may include, for example, a near field communication (NFC) antenna, a wireless charging antenna, and/or a magnetic secure transmission (MST) antenna. The antenna 370 may, for example, perform local area communication with an external device or wirelessly transmit and receive power required for charging. In another embodiment, the antenna structure may be configured by the side bezel structure 331 and/or a portion of the first support member 332 or a combination thereof.

According to various embodiments of the disclosure, the electronic device may include a plurality of communication devices 390. For example, for a MIMO implementation, specific communication devices of the plurality of communication devices 390 may be implemented to transmit and receive radio waves having different characteristics (tentatively referred to as radio waves in frequency bands A and B). As another example, for a diversity implementation, specific communication devices of the plurality of communication devices 390 may be, for example, configured to simultaneously transmit and receive radio waves having the same characteristic (tentatively referred to as radio waves having frequencies A1 and A2 in frequency band A). As still another example, for a diversity implementation, other specific communication devices of the plurality of communication devices 390 may be, for example, configured to simultaneously transmit and receive radio waves having the same characteristic (tentatively referred to as radio waves having frequencies B1 and B2 in the frequency band B). In another embodiment of the disclosure, the electronic device may also include two communication devices, but in another embodiment of the disclosure, the electronic device 101 may include four communication devices to simultaneously implement MIMO and diversity. In still another embodiment, the electronic device 101 may include only one communication device 390.

According to one embodiment, when one communication device is disposed at a first location of the printed circuit board 340 in consideration of transmission/reception characteristics of radio waves, another communication device may be disposed at a second location of the printed circuit board 340, which is separated from the first location. As another example, one communication device and another communication device may be arranged in consideration of a mutual separation distance according to diversity characteristics.

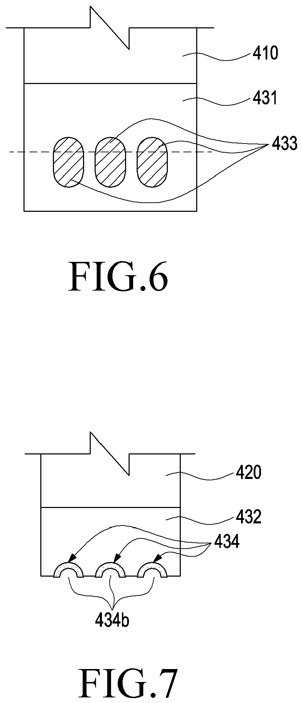

According to one embodiment, the at least one communication device 390 may include a wireless communication circuit that processes radio waves transmitted and received in an ultrahigh frequency band (e.g., 6 GHz or more and 300 GHz or less). The radiation conductor(s) (e.g., the radiation conductor 690 of FIG. 7A) of the at least one communication device 390 may be configured by, for example, a patch-type radiation conductor or a radiation conductor having a dipole structure and extending in one direction or may form an antenna array by arraying the plurality of the radiation conductors. A chip and the like (e.g., integrated circuit chip) implemented by a part of the wireless communication circuit may be disposed on one side of a region in which the radiation conductor is disposed or on a surface facing the opposite direction of the surface on which the radiation conductor is disposed, and for example, may be electrically connected to the radiation conductor(s) through a wire formed of a printed circuit pattern.

As shown in FIG. 4 above, the printed circuit board 340 may include at least one circuit element 391 or at least one first electronic component 392 mounted thereon, and another printed circuit board 390a may include at least one electronic component 390a-1 (e.g., fingerprint sensor module) mounted thereon. The printed circuit board 340 may include a first connection terminal 393, and one end of the another printed circuit board 390a may include the at least one second electronic component 421 (e.g., fingerprint sensor module). The other end of the another printed circuit board 390a may include a second connection terminal 390a-2 electrically connected to the first connection terminal 393 by soldering. The first and second connection terminals 393 and 390a-2 may be provided on a rear surface of the display 330 (e.g., active region of display).

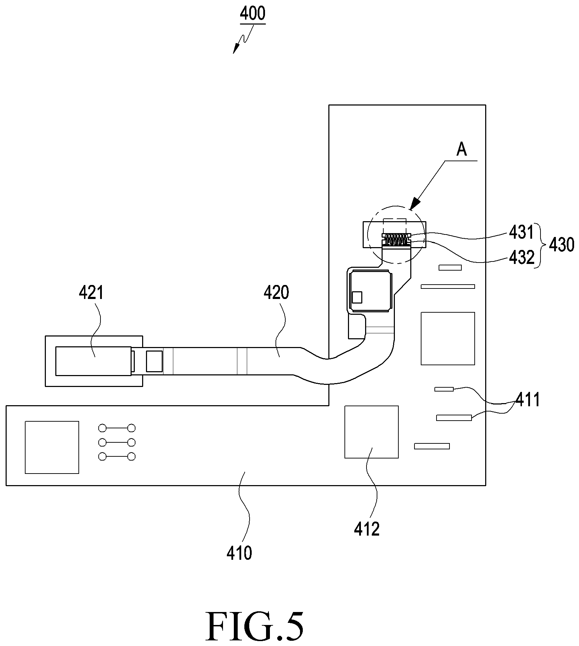

Hereinafter, various connection structures 400 in which the first connection terminal 393 of the printed circuit board 340 and the second connection terminal 390a-2 of the another printed circuit board 390a are electrically connected by soldering will be described in detail with reference to FIGS. 5 and 6 below.

FIG. 5 is a plan view illustrating a coupling state of a connection structure 430 included in the first and second circuit boards 400 according to various embodiments of the disclosure, FIG. 6 is a plan view of enlarged part A of FIG. 5, illustrating a first connection pad 433 included in a first connection terminal 431 of the first circuit board 410, among components of the connection structure 430, and FIG. 7 is a plan view of enlarged part A of FIG. 5, illustrating a second connection pad 434 included in a second connection terminal 432 of the second circuit board 420, among the components of the connection structure 430.

Referring to FIGS. 5 to 7, the circuit board 400 according to various embodiments may include the first and second circuit boards 410 and 420, and the connection structure 430, for example, the first circuit board 410 may be included in an electronic device 101 of FIG. 2, and may allow at least one circuit element 411 or at least one first electronic component 412 included in the electronic device 101 of FIG. 2 to be mounted thereon. For example, the at least one circuit element 411 may include at least one of a passive element (e.g., passive chip), an active element (e.g., active chip), and a transistor. The at least one circuit element 411 may employ another circuit elements 411 other than the passive element, the active element, and the transistor. The at least one first electronic component 412 may include at least one of a shield can, a connector, and a connection terminal. The at least one first electronic component 412 may employ another electronic component other than the shield can, the connector, and the connection terminal.

The second circuit board 420 may be included in the electronic device 101 of FIG. 2, and may allow at least one second electronic component 421 included in the electronic device 101 of FIG. 2 to be mounted thereon. At least a portion of one end of the second circuit board 420 may include the at least one second electronic component 421, and at least a portion of the other end of the second circuit board 420 may include at least one second connection terminal 432 to be described later. For example, the at least one second electronic component 421 may include at least one of a fingerprint sensor module, a camera module, a plurality of sensor modules, a biometric module, a display panel, a semiconductor, and a touch panel. The at least one second electronic component 421 may employ another electronic component other than the above-described components.

The connection structure 430 may electrically connect the first circuit board 410 and the second circuit board 420 to each other by soldering without using an existing connector (not shown).

The first circuit board 410 may include a printed circuit board (PCB), the printed circuit board may include a main printed circuit board included in the electronic device 101 of FIG. 2, and the second circuit board 420 may include an FPCB.

According to various embodiments, the circuit board 400 may include a rigid flexible circuit board (RF PCB) including the first circuit board 410 which is hard and the second circuit board 420 that is a flexible board. For example, the rigid flexible circuit board (RF PCB) may be a board including the first and second circuit boards 410 and 420 together.

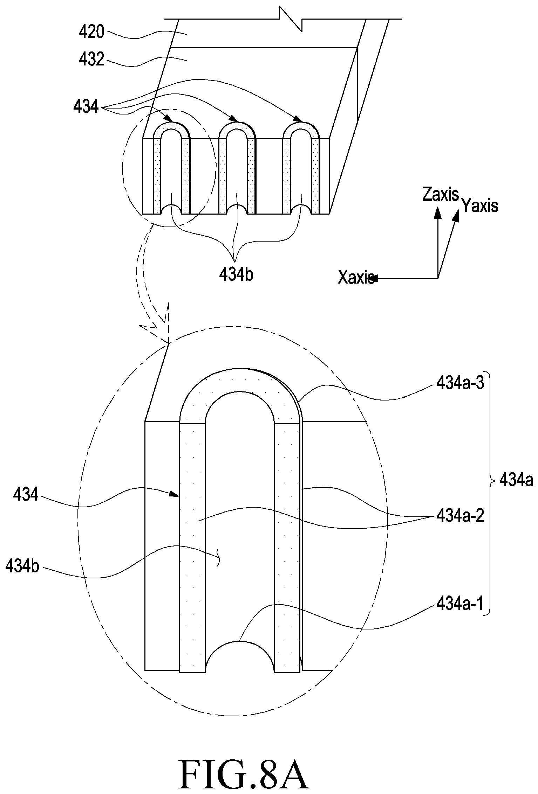

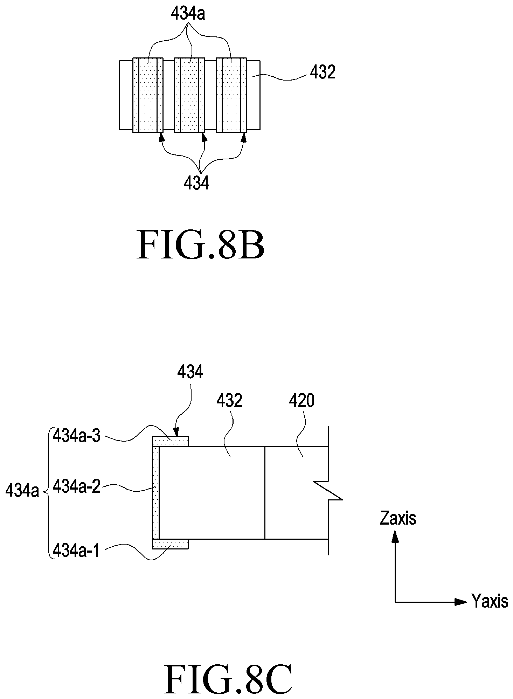

FIG. 8A is a three-dimensional view illustrating the second connection pad 434 included in the second circuit board among the components of the connection structure 430 according to various embodiments of the disclosure, FIG. 8B is a front view illustrating the second connection pad 434 included in the second circuit board 420 among the components of the connection structure 430 according to various embodiments of the disclosure, and FIG. 8C is a side view illustrating the second connection pad 434 included in the second circuit board 420 among the components of the connection structure 430 according to various embodiments of the disclosure.

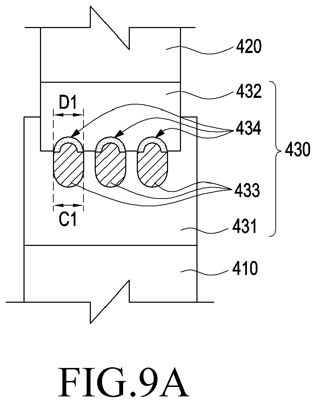

Referring to FIGS. 8A, 8B, and 8C, the connection structure 430 of FIG. 9A may include the first connection terminal 431 of FIG. 9A included in the first circuit board 410 in FIG. 9A, the second connection terminal 432 included in the second circuit board 420, and at least one first connection pad 433 of FIG. 9A and at least one second connection pad 434. For example, the at least one first connection pad 433 of FIG. 9A may face the second connection pad 434 to be described later and may be provided at the first connection terminal 431 of FIG. 9A to be electrically connected to the second connection pad 434 by soldering. The second connection pad 434 may face the first connection pad 433 of FIG. 9A and may be provided at the second connection terminal 432 to be electrically connected to the first connection terminal 431 of FIG. 9A by soldering.

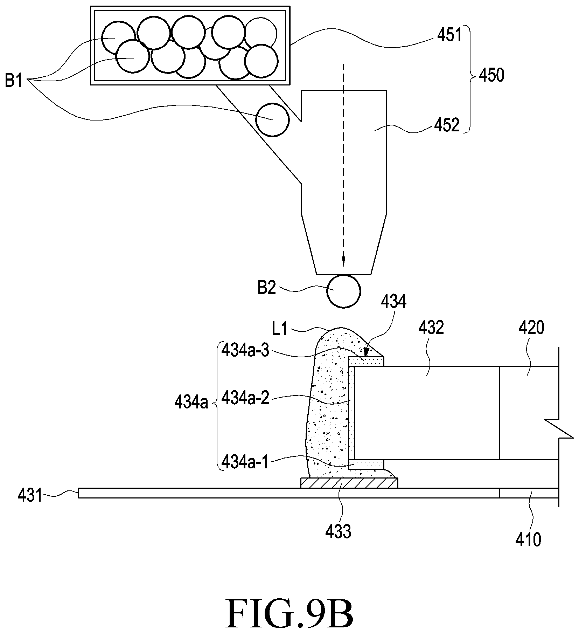

The at least one second connection pad 434 may include a plurality of contact members 434a which are in surface contact with a solder L1 in FIG. 9B to increase a contact area with the solder L1 in FIG. 9B formed by the soldering.

For example, the plurality of contact members 434a may include first, second, and third contact members 434a-1, 434a-2, and 434a-3.

As shown in FIGS. 8A and 8C, the first contact member 434a-1 may be disposed on the lower surface of the second connection terminal 432, may be disposed in the horizontal direction (Y axis direction) along the longitudinal direction of the second connection terminal 432, and may face and overlap the upper surface of the at least one first connection pad 433. In this case, the first contact member 434a-1 and the upper surface of the at least one first connection pad 433 of FIG. 9A may be electrically connected to each other.

The second contact member 434a-2 may extend in the vertical direction (Z axis direction) from the first contact member 434a-1 and may be disposed on a side surface of the second connection terminal 432 to be in contact with the solder L1 in FIG. 9B.

The third contact member 434a-3 may extend in the horizontal direction (Y axis direction) from the second contact member 434a-2 and may be disposed on the upper surface of the second connection terminal 432 to be in contact with the solder L1 in FIG. 9B.

According to various embodiments, the first, second, and third contact members 434a-1, 434a-2, and 434a-3 may be plated around the surfaces of the upper surface, the side surface, and the lower surface of the second connection terminal 432.

The second connection pad 434 may be configured by the first, second, and third contact members 434a-1, 434a-2, and 434a-3 to increase the contact area with the solder L1 in FIG. 9B by the soldering, so that the electrical connection between the first connection pad 433 of FIG. 9A and the second connection pad 434 can be improved by the first, second, and third contact members 434a-1, 434a-2, and 434a-3 when the first connection pad 433 of FIG. 9A and the second connection pad 434 are electrically connected to each other by soldering. Accordingly, the first connection pad 433 of FIG. 9A and the second connection pad 434 can improve reliability of the electrical connection therebetween.

According to various embodiments, the at least one second connection pad 434 may be formed in a curved shape. For example, the at least one second connection pad 434 may be formed in a horseshoe shape as shown in FIG. 7. The at least one second connection pad 434 may employ at least one of a planar shape, an oval shape, a hemispherical shape, and a U-letter shape other than the horseshoe shape.

According to various embodiments, a width D1 of FIG. 9A of the at least one second connection pad 434 may be the same as or smaller than a width C1 of FIG. 9A of the at least one first connection pad 433 of FIG. 9A. Therefore, the at least one second connection pad 434 can facilitate the contact between the first connection pad 433 of FIG. 9A and the second connection pad 434 and can further improve the contact with the L1 of FIG. 9B by the soldering.

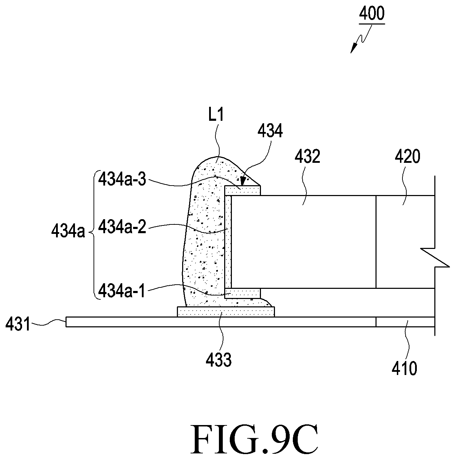

FIG. 9A is a plan view illustrating operating states of the first and second connection pads included in the first and second circuit boards 410 and 420 according to various embodiments of the disclosure, FIG. 9B is a side view illustrating an operation state of a soldering device 450 according to various embodiments of the disclosure, and FIG. 9C is a side view illustrating a state in which the first and second connection pads 433 and 434 included in the first and second circuit boards 410 and 420, respectively, are electrically connected to each other by soldering L1 according to various embodiments of the disclosure.

Referring to FIGS. 9A, 9B, and 9C, the connection structure 430 included in the circuit board 400 may include the first connection terminal 431 included in the first circuit board 410, the second connection terminal 432 included in the second circuit board 420, the at least one first connection pad 433 included in the first connection terminal 431, and the second connection pad 434 included in the second connection terminal 432.

The first circuit board 410 may include at least one circuit element 411 or at least one first electronic component 412 mounted thereon, and the second circuit board 420 may include at least one second electronic component 421 (e.g., fingerprint sensor module) mounted thereon.

As mentioned in FIG. 5 above, one end of the second circuit board 420 may include the at least one second electronic component 421 (e.g., fingerprint sensor module), and the other end of the second circuit board 420 may include the second connection terminal 432 including the at least one second connection pad 434.

The at least one second connection pad 434 may form a plurality of contact members 434a, and the plurality of contact members 434a may include the first, second, and third contact members 434a-1, 434a-2, and 434a-3. The first contact member 434a-1 may be plated on the lower surface of the second connection terminal 432, the second contact member 434a-2 may be plated on a side surface of the second connection terminal 432, and the third contact member 434a-3 may be plated on the upper surface of the second connection terminal 432.

In this state, the lower surface of the second connection pad 434 may be overlappingly placed on the upper surface of the first connection pad 433 provided at the first connection terminal 431.

As shown in FIG. 9B, a molten solder ball B2 may be applied by the soldering device 450 to the upper surfaces of the overlapping first and second connection pads 433 and 434. For example, the molten solder ball B2 may be simultaneously applied to the first contact member 434a-1 of the second connection pad 434 and a portion between the upper surface of the first connection pad 433 and the upper surface of the second connection pad 434 to electrically connect the first and second connection pads 433 and 434 to each other. The molten solder ball B2 may be applied to the second contact member 434a-2 on a side surface of the second connection pad 434 and the third contact member 434a-3 on the upper surface of the second connection pad 434.

Since an accommodating space 434b which accommodates the molten solder ball B2 is formed in the second connection pad 434, the molten solder ball B1 may be applied to the second connection pad 434 and simultaneously be accommodated in the accommodating space 434b. For example, the second connection pad 434 may be formed in a horseshoe shape, and an accommodating space 434b may be formed in the second connection pad 434 having a horseshoe shape. The accommodating space may come into contact with the molten solder ball B2 while accommodating the same. When a predetermined time elapses, the liquid solder ball B2 may be changed into a solid solder ball, and the solid solder ball may be filled and accommodated in the accommodating space 434b.

According to various embodiments, when the molten solder ball B2 is applied by the soldering device 450 to the upper surfaces of the overlapping first and second connection pads 433 and 434, the molten solder ball B2 may be introduced into a gap between the first and second connection pads to be in contact with the first contact member 434a-1 of the second connection pad 434, and at the same time, the molten solder ball B2 may be in contact with the second and third contact members 434a-2 and 434a-3 disposed on the side surface and the upper surface of the second connection pad 434, respectively. Accordingly, when a predetermined time elapses, the molten solder ball B2 may be changed into a solid solder ball, and the solid solder ball may come into contact with the first, second, and third contact members 434a-1, 434a-2, 434a-3 and simultaneously be soldered L1 thereto so as to electrically connect the first and second connection pads 433 and 434 to each other.

According to various embodiments, the soldering device 450 may include a non-contact soldering device. The soldering device 450 may include a bumping tool 451 containing a plurality of solid solder balls B1, and a capillary 452 connected to the bumping tool 451 and may be configured to receive the solid solder balls B1. The capillary 452 may melt the solid solder ball B1 supplied from the bumping tool 451 by using a laser to form the liquid solder ball B2. In this case, the application inlet of the capillary 452 may allow the liquid solder balls B2 to be applied onto the upper surfaces of the overlapping first and second connection pads 433 and 434 through jetting-spraying. Accordingly, the soldering device 450 may supply the liquid solder balls B2 to the overlapping first and second connection pads 433 and 434. The supplied liquid solder balls B3 may be changed into solid solder balls when a predetermined time elapses. In this case, the solid solder balls may be soldered to electrically connect the first and second connection pads 433 and 434 to each other.

The liquid solder ball B2 is applied by the soldering device 450 to the upper surfaces of the overlapping first and second connection pads 433 and 434, and the liquid solder ball B2 may be applied to the first, second, and third contact members 434a-1, 434a-2, and 434a-3 of the second connection pad 434 and be soldered L1 thereto at the same time. In this case, the first and second connection pads 433 and 434 may be soldered to each other by the liquid solder ball B1 to be electrically connected to each other. Accordingly, the second connection pad 434 can increase the surface contact with the solder L1 by the first, second, and third contact members 434a-1, 434a-2, and 434a-3, the first and second connection pads 433 and 434. Accordingly, the first and second connection pads 433 and 434 can improve the electrical connection therebetween. In addition, the first and second connection pads 433 and 434 can prevent cracks occurring when the first and second connection pads 433 and 434 are connected using an existing connector (not shown), thereby reducing the occurrence of defective product and further improving the electrical connection of a product. In addition, the first and second connection pads 433 and 434 do not require an existing connector, thereby reducing a manufacturing cost of a product.

The soldering process by the soldering device 450 is referred to as a non-contact jet soldering process. For example, the non-contact jet soldering process as mentioned above is a process of rapidly melting the solid spherical solder ball B2 from the bumping tool 451 by using a laser and jetting spraying (e.g., high pressure injection) the same to electrically connect the first and second connection pads 433 and 434 of the first and second circuit boards 410 and 420 to each other. Therefore, since the non-contact jet soldering process is not a process of electrically connecting the first and second connection pads 433 and 434 of the first and second circuit boards 410 and 420 to each other by heat, not only the first and second circuit boards 410 and 420 can be prevented from being damaged by heat, but also other electronic components included in the electronic device other than the first and second circuit boards 410 and 420 can be prevented from being damaged by heat. For example, when the other electronic components include a fingerprint sensor module, the fingerprint sensor module may be provided on the rear surface of the display 330 of FIG. 4 to implement a fingerprint sensor on the front display. In this case, since heat is not applied to the first and second connection pads 433 and 434 when the second connection pad 434 of the fingerprint sensor module and the first connection pad 433 of the first circuit board 410 are electrically connected to each other by the non-contact jet soldering process, the display (e.g., active region of the display) can be prevented from being damaged by heat.

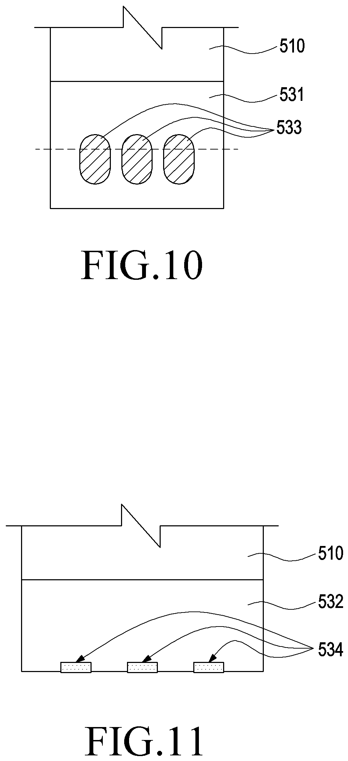

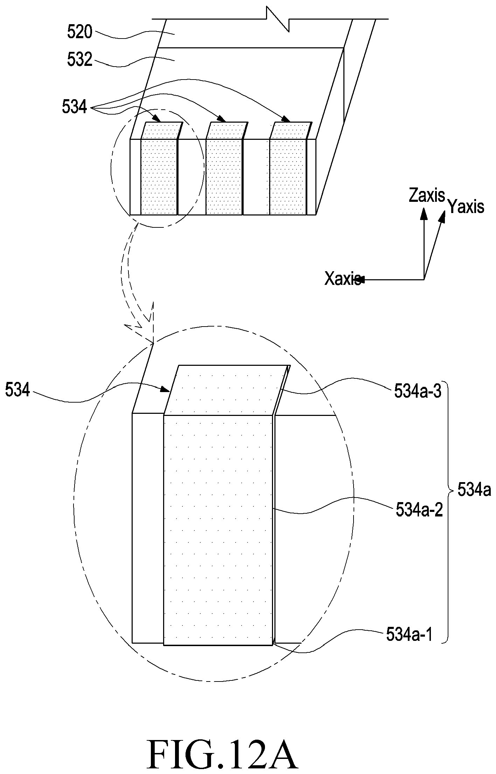

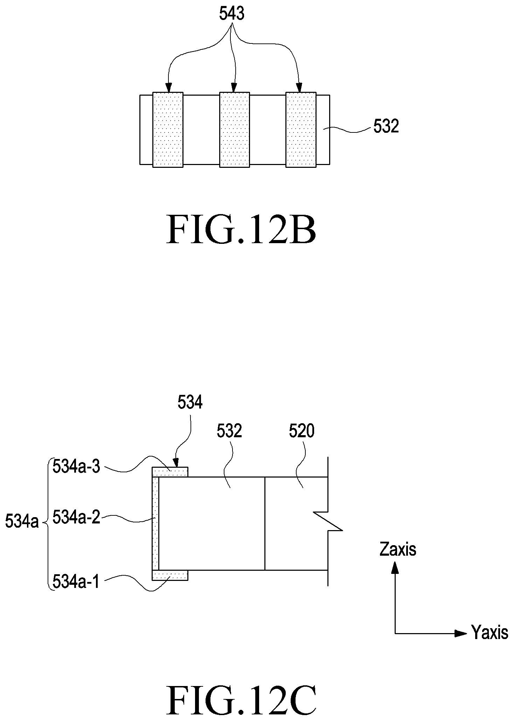

FIG. 10 is a plan view illustrating a first connection pad 533 included in a first connection terminal 531 of a first circuit board 510, among components of a connection structure 530 according to various other embodiments of the disclosure, FIG. 11 is a plan view illustrating a second connection pad 534 included in a second connection terminal 532 of a second circuit board 520, among the components of the connection structure 530 according to various other embodiments of the disclosure, FIG. 12A is a three-dimensional view illustrating the second connection pad 534 included in the second circuit board according to various other embodiments of the disclosure, FIG. 12B is a front view illustrating the second connection pad 534 included in the second circuit board 520 according to various other embodiments of the disclosure, and FIG. 12C is a side view illustrating the second connection pad 534 included in the second circuit board 520 according to various other embodiments of the disclosure.

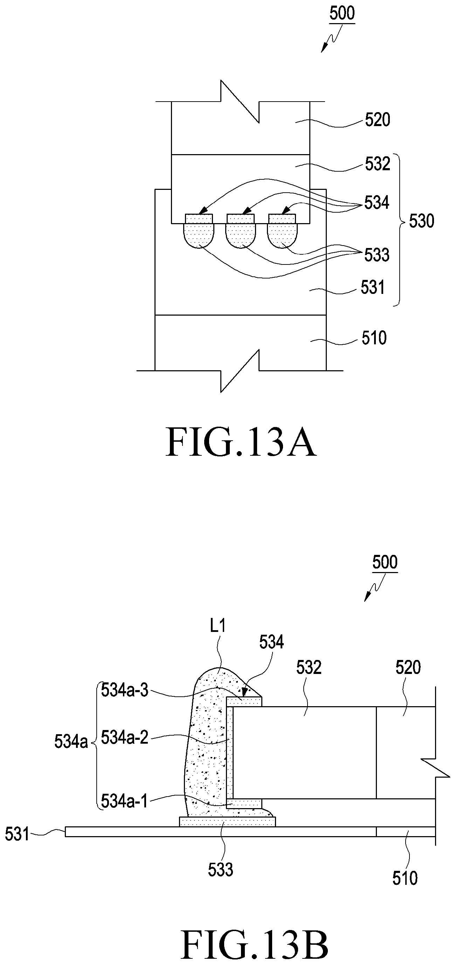

Referring to FIGS. 10, 11, and 12A, 12B, and 12C, the circuit board 500 of FIG. 13 according to various embodiments may include first and second circuit boards 510 and 520, and a connection structure 530. For example, the first circuit board 510 may be included in the electronic device 101 of FIG. 2 and may allow at least one circuit element 411 of FIG. 5 or at least one first electronic component 412 of FIG. 5 included in the electronic device 101 of FIG. 2 to be mounted thereon.

The second circuit board 520 may be included in the electronic device 101 of FIG. 2 and may allow the at least one second electronic component 412 of FIG. 5 included in the electronic device 101 of FIG. 2 to be mounted thereon.

The connection structure 530 may electrically connect the first circuit board 510 and the second circuit board 520 to each other by soldering without using an existing connector (not shown).

The connection structure 530 may include a first connection terminal 531 included in the first circuit board 510, a second connection terminal 532 included in the second circuit board 520, at least one first connection pad 533, and at least one second connection pad 534. For example, the at least one first connection pad 533 may face the second connection pad 534 to be described later and may be provided at the first connection terminal 531 to be electrically connected to the second connection pad 534 by soldering. The second connection pad 534 may face the first connection pad 533 and may be provided at the second connection terminal 532 to be electrically connected to the first connection terminal 531 by soldering.

As shown in FIG. 11, the at least one second connection pad 534 may have a straight planar shape.

The at least one second connection pad 534 having the shape may include a plurality of contact members 534a to increase a contact area where the same is in contact with the solder L1 formed by the soldering.

For example, the plurality of contact members 534a may include first, second, and third contact members 534a-1, 534a-3, and 534a-3.

As shown in FIGS. 12A, 12B, and 12C, the first contact member 534a-1 may be disposed on the lower surface of the second connection terminal 532, may be disposed in the horizontal direction (Y axis direction) along the longitudinal direction of the second connection terminal 532, and may face and overlap the upper surface of the at least one first connection pad 533. In this case, the first contact member 534a-1 and the upper surface of the at least one first connection pad 533 may be electrically connected to each other.

The second contact member 534a-2 may extend in the vertical direction (Z axis direction) from the first contact member 534a-1 and may be disposed on a side surface of the second connection terminal 532 to be in contact with the solder L1.

The third contact member 534a-3 may extend in the horizontal direction (Y axis direction) from the second contact member 534a-2 and may be disposed on the upper surface of the second connection terminal 532 to be in contact with the solder L1.

According to various embodiments, the first, second, and third contact members 534a-1, 534a-3, and 534a-3 may be plated around the upper surface, the side surface, and the lower surface of the second connection terminal 532.

FIG. 13A is a plan view illustrating operating states of the first and second connection pads 533 and 534 included in the first and second circuit boards 510 and 520, respectively, according to various other embodiments of the disclosure, and FIG. 13B is a side view illustrating the operating states of the first and second connection pads 533 and 534 included in the first and second circuit boards 510 and 520, respectively, according to various other embodiments of the disclosure.

Referring to FIGS. 13A and 13B, the connection structure 530 included in the circuit board may include a first connection terminal 531 included in the first circuit board 510, a second connection terminal 532 included in the second circuit board 520, at least one first connection pad 533 included in the first connection terminal 531, and a second connection pad 534 included in the second connection terminal 532.

The second connection pad 534 may be formed in a straight planar shape.

The at least one planar shaped second connection pad 534 may form a plurality of contact members 534a, and the plurality of contact members 534a may include the first, second, and third contact members 534a-1, 534a-2, and 534a-3. The first contact member 534a-1 may be plated on the lower surface of the second connection terminal 532, the second contact member 534a-2 may be plated on a side surface of the second connection terminal 532, and the third contact member 534a-3 may be plated on the upper surface of the second connection terminal 532.

In this state, the lower surface of the second connection pad 534 may be overlappingly placed on the upper surface of the first connection pad 533 provided at the first connection terminal 531.

As shown in FIG. 13B, a molten solder ball B2 of FIG. 9B may be applied by the soldering device 450 of FIG. 9B to the upper surfaces of the overlapping first and second connection pads 533 and 534. For example, the molten solder ball B2 of FIG. 9B may be applied to the first contact member 534a-1 of the second connection pad 534 and a portion between the upper surface of the first connection pad 533 and the upper surface of the second connection pad 534 at the same time to electrically connect the first and second connection pads 533 and 534 to each other. The molten solder ball B2 of FIG. 9B may be applied to the second contact member 534a-2 on a side surface of the second connection pad 534 and the third contact member 534a-3 on the upper surface of the second connection pad 534.

According to various embodiments, when the molten solder ball B2 of FIG. 9B is applied by the soldering device 450 of FIG. 9B to the upper surfaces of the overlapping first and second connection pads 533 and 534, the molten solder ball B2 of FIG. 9B may be introduced into a gap between the first and second connection pads 533 and 534 to be in contact with the first contact member 534a-1 of the second connection pad 534, and at the same time, the molten solder ball B2 of FIG. 9B may be in contact with the second and third contact members 534a disposed on the side surface and the upper surface of the second connection pad 534, respectively. Accordingly, when a predetermined time elapses, the molten solder ball B2 of FIG. 9B may be changed into a solid solder ball, and the solid solder ball B1 may come into contact with the first, second, and third contact members 534a-1, 534a-2, 534a-3 and be soldered thereto at the same time so as to electrically connect the first and second connection pads 533 and 534 to each other.

Accordingly, the liquid solder ball B2 in FIG. 9B is applied by the soldering device 450 in FIG. 9B to the upper surfaces of the overlapping first and second connection pad 533 and 534 having a planar shape, and the liquid solder ball B2 in FIG. 9B may be applied to the first, second, and third contact members 534a-1, 534a-2, and 534a-3 of the planar shaped second connection pad 534 and be soldered thereto at the same time. For example, the planar shaped second connection pad 534 can facilitate the application of the liquid solder ball B2 in FIG. 9B.

Accordingly, the first and second connection pads 533 and 534 can facilitate a soldering process by the liquid solder ball B2 of FIG. 9B and thus can improve the manufacturing process of the product.

According to various embodiments of the disclosure, as described above in FIGS. 5 and 9A, the circuit board 400 including the connection structure 430 may include: a first circuit board 410 on which at least one circuit element 411 or at least one first electronic component 412 included in the electronic device 101 of FIG. 2 is mounted; a second circuit board 420 on which at least one second electronic component 421 included in the electronic device is mounted; and a connection structure 430 electrically connecting the first circuit board and the second circuit board to each other by soldering. The connection structure 430 may include: a first connection terminal disposed on the first circuit board and including at least one first connection pad; and a second connection terminal disposed on the second circuit board and including at least one second connection pad. The at least one second connection pad may face the at least one first connection pad and may be electrically connected to the at least second connection pad by the soldering, and the at least one second connection pad may include a plurality of contact members which are in surface contact with a solder provided by the soldering.

According to various embodiments of the disclosure, the first circuit board may include a printed circuit board (PCB), and the second circuit board may include an FPCB.

According to various embodiments of the disclosure, at least a portion of one end of the second circuit board may include the at least one second electronic component, and at least a portion of the other end of the second circuit board may include a second connection terminal.

According to various embodiments of the disclosure, the at least one circuit element may include at least one of a passive element, an active element, and a transistor.

According to various embodiments of the disclosure, the at least one first electronic component may include at least one of a shield can, a connector, and a connection terminal, and the at least one second electronic component may include at least one of a fingerprint sensor module, a camera module, a plurality of sensor modules, a biometric module, a display panel, a semiconductor, and a touch panel.

According to various embodiments of the disclosure, the plurality of contact members 434a in FIG. 8A may include: a first contact member 434a-1 of FIG. 8A disposed on the lower surface of the second connection terminal and facing and overlapping the upper surface of the at least one first connection pad; a second contact member 434a-3 of FIG. 8A disposed on a side surface of the second connection terminal; and a third contact member 434a-3 of FIG. 8A disposed on the upper surface of the second connection terminal.

According to various embodiments of the disclosure, the at least one second connection pad may have a curved shape.

According to various embodiments of the disclosure, the at least one second connection pad, when viewed from above, may have at least one of a horseshoe shape, a planar shape, an elliptical shape, a hemispherical shape, and a U-letter shape.

According to various embodiments of the disclosure, a width of the at least one second connection pad may be equal to or smaller than a width of the at least one first connection pad.

According to various embodiments of the disclosure, the circuit board may include a rigid flexible circuit board (PCB).

According to various embodiments of the disclosure, an electronic device may comprise: a housing comprising a front plate, a rear plate facing in an opposite direction from the front plate, and a side surface surrounding a space between the front plate and the rear plate; a first circuit board located inside the housing, and on which at least one circuit element or at least one first electronic component included in the electronic device is mounted; a second circuit board located inside the housing, and on which at least one second electronic component included in the electronic device is mounted; and a connection structure electrically connecting the first circuit board and the second circuit board to each other by soldering. The connection structure may include: a first connection terminal disposed on the first circuit board and includes at least one first connection pad; and a second connection terminal disposed on the second circuit board and includes at least one second connection pad. The at least one second connection pad may face the at least one first connection pad and may be electrically connected to the at least one first connection pad by soldering, and the at least one second connection pad may include a plurality of contact members which are in surface contact with a solder provided by the soldering.

According to various embodiments of the disclosure, the circuit board may include: a first circuit board including a first connection terminal; a second circuit board including a second connection terminal; at least one first connection pad disposed on the first connection terminal; and at least one second connection pad disposed on the second connection terminal, facing the at least one first connection pad, and electrically connected to the at least one first connection pad by soldering. The at least one second connection pad may include a plurality of contact members which are in surface contact with a solder provided by the soldering.

The circuit board including the connection structure and the electronic device including the same according to the various embodiments of the disclosure, described above, are not limited by the above-described embodiments and drawings, and the possibility of various substitutions, modifications, and changes within the technical scope of the disclosure will be apparent to those of ordinary skill in the art to which the disclosure belongs.

## Claims

1. An electronic device comprising a circuit board comprising a connection structure, the electronic device comprising:
a housing comprising a front plate, a rear plate facing in an opposite direction from the front plate, and a side surface surrounding a space between the front plate and the rear plate;
a first circuit board located inside the housing, and on which at least one circuit element or at least one first electronic component included in the electronic device is mounted;
a second circuit board located inside the housing, and on which at least one second electronic component included in the electronic device is mounted; and
a connection structure electrically connecting the first circuit board and the second circuit board to each other by soldering,
wherein the connection structure comprises:
a first connection terminal disposed on the first circuit board and comprises at least one first connection pad; and
a second connection terminal disposed on the second circuit board and comprises at least one second connection pad,
wherein the at least one second connection pad faces the at least one first connection pad and is electrically connected to the at least one first connection pad by soldering, and
wherein the at least one second connection pad comprises a plurality of contact members which are in surface contact with a solder provided by the soldering.

2. The electronic device comprising a circuit board of claim 1, wherein the first circuit board comprises a PCB, and
wherein the second circuit board comprises an FPCB.

3. The electronic device comprising a circuit board of claim 1, wherein at least a portion of one end of the second circuit board comprises the at least one second electronic component, and at least a portion of the other end of the second circuit board comprises the second connection terminal.

4. The electronic device comprising a circuit board of claim 1, wherein the plurality of contact members comprises:
a first contact member disposed on a lower surface of the second connection terminal and facing and overlapping an upper surface of the at least one first connection pad;
a second contact member disposed on a side surface of the second connection terminal; and
a third contact member disposed on an upper surface of the second connection terminal.

5. The electronic device comprising a circuit board of claim 1, wherein the at least one second connection pad has a curved shape.

6. The electronic device comprising a circuit board of claim 1, wherein the at least one second connection pad, when viewed from above, has at least one of a horseshoe shape, a planar shape, an elliptical shape, a hemispherical shape, or a U-letter shape.

7. The electronic device comprising a circuit board of claim 1, comprising:
a first circuit board comprising a first connection terminal;
a second circuit board comprising a second connection terminal;
at least one first connection pad disposed on the first connection terminal; and
at least one second connection pad disposed on the second connection terminal, facing the at least one first connection pad, and electrically connected to the at least one first connection pad by soldering,
wherein the at least one second connection pad comprises a plurality of contact members which are in surface contact with a solder provided by the soldering.

8. The electronic device comprising a circuit board of claim 1, wherein the at least one circuit element comprises at least one of a passive element, an active element, and a transistor.

9. The electronic device comprising a circuit board of claim 1, wherein the at least one first electronic component comprises at least one of a shield can, a connector, and a connection terminal, and
wherein the at least one second electronic component comprises at least one of a fingerprint sensor module, a camera module, a plurality of sensor modules, a biometric module, a display panel, a semiconductor, and a touch panel.

10. The electronic device comprising a circuit board of claim 1, wherein a width of the at least one second connection pad is equal to or smaller than a width of the at least one first connection pad.

11. The electronic device comprising a circuit board of claim 1, wherein the circuit board comprises a rigid flexible PCB.
